# EUROPEAN PATENT APPLICATION

(11) **EP 4 773 628 A1**
(43) Date of publication of application: **08.07.2026**
(21) Application number: 26150015.1
(22) Date of filing: 02.01.2026
(51) Int. Cl.: H04R 3/02, H03G 3/32

(54) **LEVEL DEPENDENT MICROPHONE GAIN**

(30) Priority: 03.01.2025 US 202519009665
(71) Applicant: Harman Becker Automotive Systems, Inc., Novi, MI 48377 (US)
(72) Inventor: SCHMIDT, Skyler L, Detroit, MI, 48208 (US); DAFTUAR, Rishi, Ypsilanti, MI, 48197 (US)
(74) Representative: Rummler, Felix

(57) **Abstract**

In at least one embodiment, an audio system is provided. The audio system includes one or more microphones and at least one controller. The one or more microphones are positioned within a listening space to provide a captured audio input signal. The at least one controller is programmed to receive the captured audio input signal and to receive a first signal indicative of an audio level in the listening space. The at least one controller determines a gain amount based on the audio level and to adjusts the captured audio input signal.

## Description

### TECHNICAL FIELD

Aspects disclosed herein generally relate to a system and method for adjusting microphone gain.

### BACKGROUND

In-vehicle audio systems often face challenges in maintaining optimal microphone gain settings across diverse use cases and dynamic environments. Conventional in-vehicle audio systems often rely on static methods to manage microphone gain, typically scaling it directly with the vehicle's audio volume. Additionally, these prior systems do not consider the wide dynamic range of media content or real-time variations in audio signal levels.

### SUMMARY

In at least one embodiment, an audio system is provided. The audio system includes at least one microphone and at least one controller. The microphone is positioned in a listening space to provide a captured audio input signal. The controller is programmed to receive the captured audio input signal, to receive a volume control signal indicative of a volume setting and to receive a media input signal. The controller is further programmed to determine a media level based on the media input signal and the volume control signal. The controller is programmed to determine a first gain level based on the volume setting and to determine a second gain level based on the level of audio. A total microphone gain level is determined based on the first gain level and the second gain level. The controlled is programmed to adjust the captured audio input signal based on the total microphone gain level.

In a further embodiment, the listening space comprises a vehicle passenger cabin.

In a further embodiment, the at least one controller is further programmed to transmit a microphone output signal corresponding to the captured audio input signal adjusted by the total microphone gain level.

In a further embodiment, the at least one controller includes a first look up table (LUT) that includes a plurality of audio levels and a plurality of gain levels. Each of the plurality of level amounts has an associated first gain level from the plurality of gain levels. The controller also includes a second lookup table (LUT) that includes a plurality of volume settings and a plurality of gain levels. Each of the plurality of level amounts has an associated second gain level from the plurality of gain levels. The controller additively combines the first gain level and the second gain level to determine the total microphone gain level.

In a further embodiment the controller is further programmed to receive a medial input signal determine the media level signal based on the media input signal and the volume control signal.

In a further embodiment, the controller is further programmed to determine the level of audio in real-time and dynamically adjusts the captured audio input signal based on the real-time audio level.

In a further embodiment, the at least one controller is further programmed to transmit an audio output signal corresponding to the adjusted captured audio input signal to one or more loudspeakers.

In at least one other embodiment, a computer-program product embodied in a non-transitory computer readable medium that is programmed and executable by one or more controllers to adjust audio. The computer-program product has instructions for receiving a captured audio input signal from one or more microphones positioned in a listening space. The computer-program product has instructions for receiving a volume control signal indicative of a volume setting and for receiving a media input signal indicative of a level of audio. The computer-program product has instructions for performing one or more of: determining a gain level based on the level of audio and a volume setting and applying the gain level to the captured audio input signal.

In at least one other embodiment a audio system is provided. The audio system includes at least one microphone and at least one controller. The microphone is positioned in a listening space to provide a captured audio input signal. A media unit provides a media input signal. The controller is programmed to receive the captured audio input signal and receive a media input signal indicative of a level of audio in real-time. The controller is programmed to determine a first gain level based on the level of audio and to dynamically adjust the captured audio input signal in real-time based on the first gain level in real-time.

### BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompany drawings in which:
FIG. 1 illustrates a system for adjusting gain in a captured audio input signal according to at least one embodiment of the present disclosure.
FIG. 2 illustrates a method for adjusting the captured audio input signal according to one embodiment of the present disclosure.

### DETAILED DESCRIPTION

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.

The present application relates to an audio system and method for providing leveldependent microphone gain. In particular, the audio system may be used in in-vehicle audio systems, designed to dynamically adjust microphone input levels to enhance the overall audio experience. The audio system manages microphone gain by incorporating post-volume media input into the signal processing path. This ensures consistent and optimized performance during various audio use cases, such as hands-free communication and immersive sound experiences, as disclosed in U.S. Patent 10,728,691 by Trestain et al.

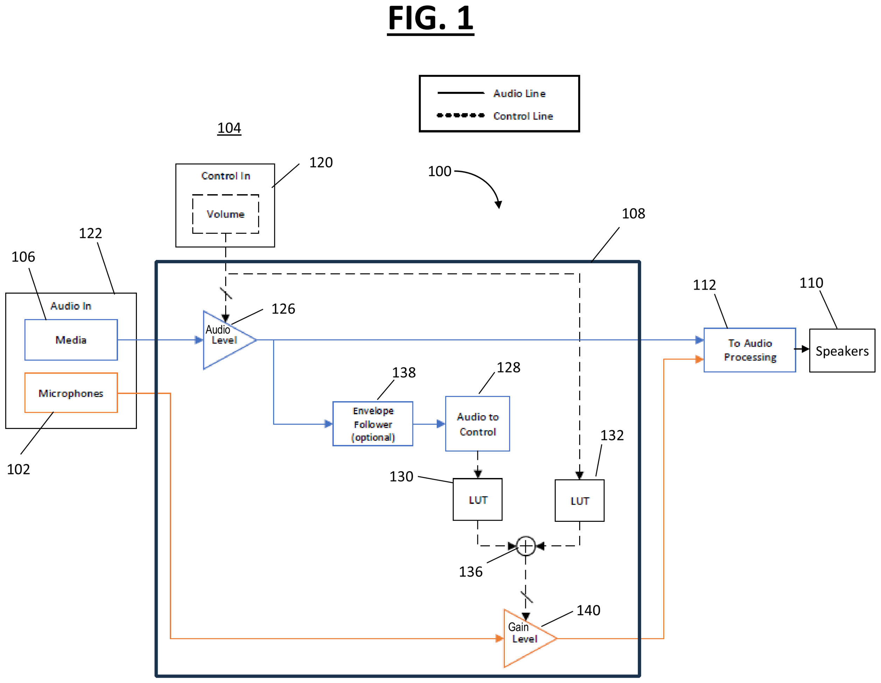

FIG. 1 illustrates a system 100 for adjusting gain in a captured audio input signal. The system 100 enables dynamic control of audio processing through real-time analysis and adjustment of microphone gain. Unlike traditional methods that rely solely on volumedependent scaling, the system 100 incorporates media level analysis to provide a more adaptive response. For example, when the volume is high, but media playback is paused or low, the system dynamically adjusts the microphone gain to maintain optimal signal clarity without unnecessary attenuation. Conversely, during high-volume playback, the system balances microphone levels to minimize feedback. This dynamic control provides real-time signal analysis, allowing the system to adapt to changing and immersive audio conditions and still deliver a consistent microphone control in the vehicle cabin.

The system 100 may control the microphone input level within the audio processing path by dynamically calibrating parameters such as reverb based on media playback levels and user interactions. By continuously analyzing and adjusting the microphone input in real-time, the system maintains an immersive audio environment while ensuring the clarity of voice and other signals captured by in-cabin microphones.

This solution in system 100 is adaptable across a range of applications both in-vehicle or outside vehicles in other listening spaces including immersive audio demonstrations, standard voice operations, and hands-free operation or in any situation where precise microphone gain control is advantageous. These aspects and others will be discussed in more detail below.

FIG. 1 generally depicts a system or audio system 100 for adjusting a captured audio input signal. The captured audio input signal is provided by at least one microphones 102 positioned in a listening space 104. In at least one embodiment, the listening space 104 includes a vehicle passenger cabin. Microphones 102 in a vehicle passenger cabin may be positioned to capture audio for various in-cabin applications. For example, the microphones 102 may be positioned in the headliner near the driver and front passenger to capture clear voice inputs for hands-free communication and voice recognition systems. Additional microphones may be embedded in the rearview mirror, sun visors, A-pillars, or other positions within the cabin to provide balanced audio coverage across the cabin. For immersive audio or concert-like experiences, microphones may also be positioned in locations that enhance spatial sound processing, such as near the rear seats or at key reflective points within the cabin.

The system 100 also has an audio line from an audio and media source 106. The audio and media source 106 may accept media audio signals, which may originate from a variety of sources, such as streaming services, radio, or onboard media players such as an FM station, an AM station, a High Definition (HD) audio station, a satellite radio provider, an input from cell phone, an input from a tablet or others. A media control block 122 provides an input media signal to a system controller 108 from the audio and media source 106.

The system 100 includes at least one controller 108 for receiving the audio input signal from each of the microphones 102 and the input media signal from the media source 106. The controller 108 may be operably coupled to one or more loudspeakers 110 positioned in the listening space 104, such as in a vehicle. The controller 108 may transmit an audio output signal to the loudspeakers 110 to playback the captured audio. An audio processing unit 112 is provided to process the audio output signal provided by the controller 108 prior to the audio output signal being provided to the loudspeakers 110.

A volume control block 120 is operably coupled to the controller 108 to provide input of the volume setting. The volume control block 120 provides the volume setting based on various control signals received from user inputs, system setting or custom profiles, for example. The system typically allows manual adjustment of volume through physical controls, such as knobs, buttons, or touchscreens, or via voice commands. The system may also adjust the volume based on feedback from conditions, such as ambient noise levels or media playback characteristics, the system can automatically adjust volume levels to maintain optimal listening conditions. The volume control block 120 provides these volume settings as a volume input signal to the controller 108.

The system 100 provides a first level block 126 that processes the media input from the media source 106 and the volume input signal from the volume control block 120. The initial audio level signal is a function of the media source input and the volume setting input.

The controller 108 includes audio control block 128, a first lookup table (LUT) 130, a second LUT 132, and a gain level block 140. In general, the controller 108 receives the media inputs and volume inputs to determine the media level. In prior systems, at normal volume levels, there would be no or only nominal microphone gain, while at higher volumes, where microphones may pick up speaker output, the microphone gain is reduced to avoid feedback. However, this past approach lacks dynamic adjustment based on contextual factors like media playback levels. The present disclosure provides adaptive control that dynamically optimizes microphone gain in real time, ensuring superior performance and user experience.

For example, the controller 108 can adapt to dynamic changes in the level of the audio, such as where the volume setting is high, but the audio is paused, or the media is low and does not need turn down the microphone gain or mute the microphone. The present disclosure is dependent on volume, but also is dependent on the audio level 126.

In this regard, the audio control block 128 may correlate the received audio level input signal to generate a corresponding control signal. The audio levels may be measured in decibels (dB) representing the relative intensity or power of sound or relative values such as dBV (relative to 1 volt) or dBFS (decibels relative to full scale, where 0 dBFS represents the maximum level, and other values are negative), or other level value that may quantifying acoustic sound in a space, signal amplitudes in devices, power levels or other characteristics in the system.

In one example, assuming that audio level is equal to an average or high level of 60dB or more, then the first LUT 130 may provide a first gain level to attenuate or reduce the gain of captured audio input signal of the microphone when audio level is low. Further, for example, assuming that audio level is equal to a low level, such as 20dB to 50db, then the first LUT 130 may provide a first gain level of to amplify the microphone when audio level is low. The first LUT 130 may include a plurality of audio values that are associated with various microphone gains. The first LUT 130 may be independent of volume.

The volume setting may be analyzed separately to adjust the captured audio input signal at a corresponding gain value set forth in the second LUT 132. For example, the second LUT 132 may include a plurality of volume setting values that are associated with various gain levels. In this regard, the second LUT 132 may provide a corresponding gain level.

Th controller 108 combines the outputs of the two LUTs 130, 132 at the summation node 136. The data processed by each LUT 130, 132 contributes to the total gain value. The first gain level from the first LUT 130 and the second gain level from the second LUT 132 may be combined additively. Inputs to the LUTs 130, 132 are processed individually and then combined into a single output at the summation node 136. The controller 108 combines two distinct control parameters, such as media level and volume setting. This configuration using modular processing enables dynamic and flexible signal processing.

The summation node 136 may provide a corresponding total gain level (or total volume/gain level) to the gain block 140 based on the volume and medial level. In contrast, in conventional audio systems, microphone gain is typically scaled with only volume settings to manage levels and prevent feedback.

It is recognized that the controller 108 may utilize one or more of the first LUT 130 and/or the second LUT 132 to increase, or amplify, the gain on the captured audio input signal provided by the microphone 102. For example, the controller 108 may adjust and increase the gain at the gain block 140 when the volume setting is high, and the media level is low. In another example, the controller 108 may adjust and increase the gain at the gain block 140 when the volume setting is low, and the media level is high. In yet another example, the controller 108 may adjust and increase the gain at the gain block 140 when the volume setting is low, and the media level is low. The system 100 may utilize the first LUT 130 and/or the second LUT 132 and the implementation of utilizing the total gain level (e.g., volume/gain level) to amplify the captured audio input signal.

It is also recognized that the controller 108 may utilize one or more of the first LUT 130 and/or the second LUT 132 to reduce, or attenuate, the gain on the captured audio input signal provided by the microphone 102. For example, the controller 108 may adjust and decrease the gain of the gain block 140 when the volume setting is high, and the media level is high. The system 100 may utilize the first LUT 130 and/or the second LUT 132 and the implementation of utilizing the total gain level (e.g., volume/gain level) to attenuate the captured audio input signal.

The controller 108 may optionally include an envelope follower 138. The envelope follower may provide additional control of the media input signal. For example, the envelope follower 138 may track amplitude variations of the incoming audio signal over time, producing a control signal that represents the signal's envelope or dynamic level. The envelope follower 138 may provide more granular or specific control when needed.

An audio processing unit 112 is provided to process the audio output signal provided by the controller 108 prior to the audio output signal being provided to the loudspeakers 110.

The system 100 may be specifically configured for in-vehicle use, where dynamically adjusting microphone gain and media playback levels in real time may enhance the audio experience. By analyzing both volume settings and media playback levels, the system 100 ensures that microphone inputs are appropriately balanced, even in scenarios where media playback is paused or at a low volume. This approach minimizes feedback and maintains voice clarity to integrate media and voice interactions. The system 100 adjusts the captured audio to enhance applications such as hands-free communication, immersive audio environments, and adaptive soundscapes tailored to the in-vehicle experience.

In another example, the system 100 may also support karaoke applications, both in-vehicle and in other environments. During karaoke sessions, the system 100 may adjust the microphone gain in real-time based on the music or media playback, ensuring that the singer's voice blends seamlessly with the background music, even during variations of the media level. This real-time adjustment may prevent overpowering or muffling of the vocal signal, for example, as the level of the song varies. The system 100 may function effectively in both automotive settings and external applications such as home karaoke systems or public entertainment venues where the listening space 104 may be a room in a home or a room in the entertainment venue or any suitable space.

The system 100 may have other consumer uses, such as in smart speakers, home entertainment systems, and personal audio devices that use one or more microphones 102 in a listening space 104. For instance, in smart speaker applications, the system can dynamically adjust microphone gain to ensure clear voice recognition while maintaining media playback volume. In typical smart speaker systems, when the user speaks in it, it turns the music or media down. But, in the system 100, the microphone gain could actually be increased when the volume of the media level is maintained.

Similarly, in home audio systems, the system 100 can enhance immersive listening experiences by adapting to user interactions without pausing or lowering media volume during voice input with one or more microphones 102. Additionally, the system 100 could be applied to portable devices or gaming setups, where dynamic microphone and audio control enhance communication clarity and immersive soundscapes. The system 100 may be suitable for a wide range of consumer audio applications.

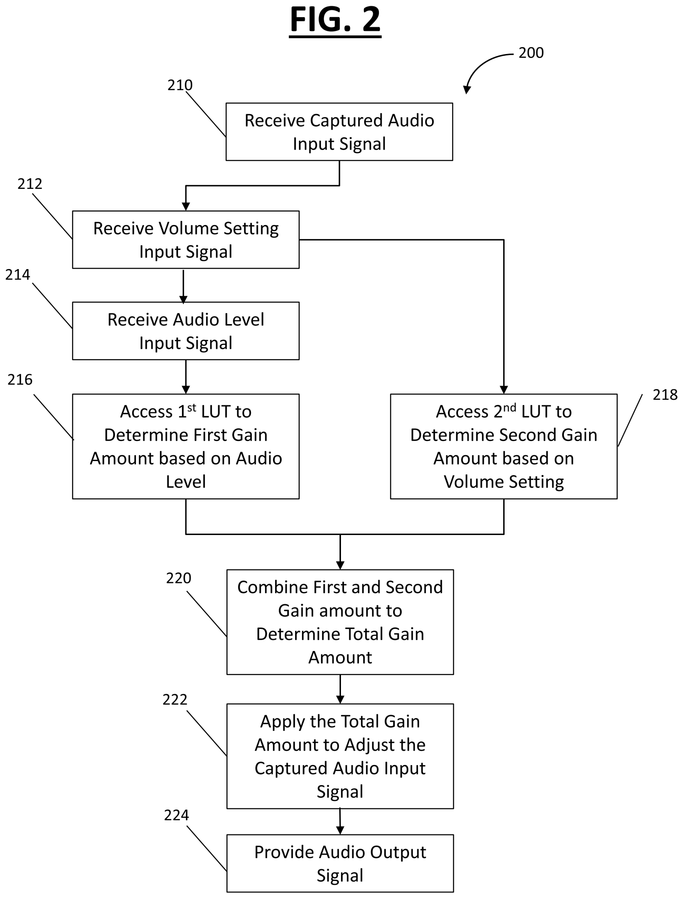

FIG. 2 is a flowchart generally showing a method 200 for adjusting the captured audio input signal provided by the one or more microphones 102 according to one embodiment of the present application.

At operation block 210, the controller 108 receives the captured audio input signal from each of the microphones 102.

At operation block 212, the controller 108 receives the volume setting signal.

At operation block 214, the controller 108 receives the audio level input signal.

At operation block 216, the controller 108 accesses the first LUT 130 to locate the audio level and associated gain for determining a first gain level.

At operation block 218, the controller 108 accesses the second LUT 132 to locate the volume setting and associated gain for determining a second gain level.

At operation block 220, the controller 108 combines the first gain level and the second gain level to determine the total gain level.

At operation block 222, the controller 108 applies the total gain level to the captured audio input signal to adjust the captured audio input signal.

At operation block 224, the controller 108 provides the audio output signal to at least one of the loudspeakers 110 or the audio processing unit 112.

It is recognized that the controllers may include various microprocessors, integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, the controllers utilize one or more microprocessors to execute a computer-program that is embodied in a non-transitory computer readable medium that is programmed to perform any number of the functions as disclosed. Further, the controllers include a housing and the various number of microprocessors, integrated circuits, and memory devices (e.g., FLASH, random access memory (RAM), read only memory (ROM), electrically programmable read only memory (EPROM), electrically erasable programmable read only memory (EEPROM) are positioned within the housing. The controllers also include hardware-based inputs and outputs for receiving and transmitting data, respectively from and to other hardware-based devices.

For example, the controller 108 may be a suitable digital signal processor (DSP) for conducting the audio signal processing. The controller 108 may include multiple or separate microprocessors, integrated circuits, memory devices, RAM, ROM, EPROM, EEPROM, software or other suitable controllers to process the media/music and also process the microphone read only memory (ROM), electrically programmable read only memory (EPROM), electrically erasable programmable read only memory (EEPROM), or other suitable variants thereof, and software. The DSP for processing the microphone and media/music signals could be located within a vehicle amplifier, computer, a vehicle head unit, central computer, domain controller, digital audio interface/mixer or other suitable digital signal processor.

In another embodiment, the volume input block 120 and/or the media input block 122 may be provided within a head unit or audio playback device. The head unit may be used in automotive infotainment systems and is capable to interface with vehicle systems, multimedia content, and communication devices. The head unit may include a central processing module configured to manage audio, video, and connectivity operations, paired with a high-resolution touchscreen display for user interaction. The head unit may be configured with wireless communication interfaces, including Bluetooth^{®} and Wi-Fi^{®}, to support hands-free calling, media streaming, and connectivity with mobile devices. The head unit may also be integrated with various external components, such as amplifiers, cameras, and navigation systems.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### FURTHER EXAMPLES

Example 1. An audio system comprising: at least one microphone positioned in a listening space to provide a captured audio input signal; at least one controller programmed to: receive the captured audio input signal; receive a volume control signal indicative of a volume setting; receive a media input signal; determine a media level based on the media input signal and the volume control signal; determine a first gain level based on the volume setting; determine a second gain level based on the level of audio; determine a total microphone gain level based on the first gain level and the second gain level; and adjust the captured audio input signal based on the total microphone gain level.

Example 2. The audio system of example 1, wherein the listening space comprises a vehicle passenger cabin.

Example 3. The audio system of example 1 or 2, wherein the at least one controller is further programmed to: transmit a microphone output signal corresponding to the captured audio input signal adjusted by the total microphone gain level.

Example 4. The audio system of any of examples 1 to 3, wherein the at least one controller includes a first look up table (LUT) that includes a plurality of audio levels and a plurality of gain levels, wherein each of the plurality of level amounts has an associated first gain level from the plurality of gain levels.

Example 5. The audio system of any of examples 1 to 4, wherein the at least one controller includes a second lookup table (LUT) that includes a plurality of volume settings and a plurality of gain levels, wherein each of the plurality of level amounts has an associated second gain level from the plurality of gain levels.

Example 6. The audio system of any of examples 1 to 5, wherein the controller additively combines the first gain level and the second gain level to determine the total microphone gain level.

Example 7. The audio system of any of examples 1 to 6, wherein the controller is further programmed to: receive a medial input signal; and determine the media level signal based on the media input signal and the volume control signal.

Example 8. The audio system of any of examples 1 to 7, wherein the controller is further programmed to: determine the level of audio in real-time; and dynamically adjust the captured audio input signal based on the real-time audio level.

Example 9. The audio system of any of examples 1 to 8, wherein the at least one controller is further programmed to transmit an audio output signal corresponding to the adjusted captured audio input signal to one or more loudspeakers.

Example 10. A computer-program product embodied in a non-transitory computer readable medium that is programmed and executable by one or more controllers to adjust audio, the computer-program product comprising instructions for: receiving a captured audio input signal from one or more microphones positioned in a listening space; receiving a volume control signal indicative of a volume setting; receiving a media input signal indicative of a level of audio; performing one or more of: determining a gain level based on the level of audio and a volume setting; and applying the gain level to the captured audio input signal.

Example 11. The computer-program product of example 10, further comprising instructions for receiving a volume input signal indicative of a volume setting; and further performing of: determining a second gain level based on the volume setting.

Example 12. The computer-program product of example 11, further performing of: determining a total gain level based on the first gain level and the second gain level, applying the total gain level to the captured audio input signal.

Example 13. The computer-program product of example 12, further comprising instructions for transmitting a microphone output signal corresponding to the captured audio input signal adjusted by the total gain level.

Example 14. An audio system comprising: at least one microphone positioned in a listening space to provide a captured audio input signal; at least one controller programmed to: receive the captured audio input signal; receive a media input signal indicative of a level of audio in real-time; determine a first gain level based on the level of audio; and dynamically adjust the captured audio input signal in real-time based on the first gain level.

Example 15. The audio system of example 14, wherein the listening space comprises a vehicle passenger cabin.

Example 16. The audio system of example 14 or 15, wherein the at least one controller includes a first lookup table (LUT) that includes a plurality of audio levels and a plurality of gain levels, wherein each of the plurality of level amounts has an associated first gain level from the plurality of gain levels.

Example 17. The audio system of any of examples 14 to 16, wherein the at least one controller is further programmed to: receive a volume input signal indicative of a volume setting; and determine a second gain level based on the volume setting.

Example 18. The audio system of example 17, wherein the at least one controller includes a second lookup table (LUT) that includes a plurality of volume settings and a plurality of gain levels, wherein each of the plurality of level amounts has a second associated gain level from the plurality of gain levels.

Example 19. The audio system of example 17 or 18, wherein the at least one controller is further programmed to: determine a total gain level based on the first gain level and the second gain level, wherein the controller dynamically adjusts the captured audio input signal based on the total gain level.

Example 20. The audio system of any of examples 17 to 19, further comprising a media unit providing the media input signal and the volume input signal indicative of a volume setting.

## Claims

1. An audio system comprising:
at least one microphone positioned in a listening space to provide a captured audio input signal;
at least one controller programmed to:
receive the captured audio input signal;
receive a volume control signal indicative of a volume setting;
receive a media input signal;
determine a media level based on the media input signal and the volume control signal;
determine a first gain level based on the volume setting;
determine a second gain level based on the level of audio;
determine a total microphone gain level based on the first gain level and the second gain level; and
adjust the captured audio input signal based on the total microphone gain level.

2. The audio system of claim 1, wherein the at least one controller is further programmed to:
transmit a microphone output signal corresponding to the captured audio input signal adjusted by the total microphone gain level.

3. The audio system of claim 1, wherein the controller additively combines the first gain level and the second gain level to determine the total microphone gain level.

4. The audio system of claim 1, wherein the controller is further programmed to:
receive a medial input signal; and
determine the media level signal based on the media input signal and the volume control signal.

5. The audio system of claim 1, wherein the controller is further programmed to:
determine the level of audio in real-time; and
dynamically adjust the captured audio input signal based on the real-time audio level.

6. A computer-program product embodied in a non-transitory computer readable medium that is programmed and executable by one or more controllers to adjust audio, the computer-program product comprising instructions for:
receiving a captured audio input signal from one or more microphones positioned in a listening space;
receiving a volume control signal indicative of a volume setting;
receiving a media input signal indicative of a level of audio;
performing one or more of:
determining a gain level based on the level of audio and a volume setting; and
applying the gain level to the captured audio input signal.

7. The computer-program product of claim 6, further comprising instructions for receiving a volume input signal indicative of a volume setting; and
further performing of:
determining a second gain level based on the volume setting.

8. The computer-program product of claim 7, further performing of:
determining a total gain level based on the first gain level and the second gain level,
applying the total gain level to the captured audio input signal.

9. The computer-program product of claim 8, further comprising instructions for transmitting a microphone output signal corresponding to the captured audio input signal adjusted by the total gain level.

10. An audio system comprising:
at least one microphone positioned in a listening space to provide a captured audio input signal;
at least one controller programmed to:
receive the captured audio input signal;
receive a media input signal indicative of a level of audio in real-time;
determine a first gain level based on the level of audio; and
dynamically adjust the captured audio input signal in real-time based on the first gain level.

11. The audio system of claim 1 or claim 10, wherein the listening space comprises a vehicle passenger cabin.

12. The audio system of claim 1 or claim 10, wherein the at least one controller includes a first lookup table (LUT) that includes a plurality of audio levels and a plurality of gain levels, wherein each of the plurality of level amounts has an associated first gain level from the plurality of gain levels.

13. The audio system of claim 10, wherein the at least one controller is further programmed to:
receive a volume input signal indicative of a volume setting; and
determine a second gain level based on the volume setting.

14. The audio system of claim 1 or claim 13, wherein the at least one controller includes a second lookup table (LUT) that includes a plurality of volume settings and a plurality of gain levels, wherein each of the plurality of level amounts has a second associated gain level from the plurality of gain levels.

15. The audio system of claim 13, wherein the at least one controller is further programmed to:
determine a total gain level based on the first gain level and the second gain level,
wherein the controller dynamically adjusts the captured audio input signal based on the total gain level.
